# EUROPEAN PATENT APPLICATION

(11) **EP 2 437 516 A1**
(43) Date of publication of application: **04.04.2012**
(21) Application number: 09845131.3
(22) Date of filing: 25.05.2009
(51) Int. Cl.: H04R 3/00, G11B 27/02

(54) **CROSS-FADER APPARATUS, MIXER APPARATUS AND PROGRAM**

(71) Applicant: Pioneer Corporation, Kanagawa 212-0031 (JP)
(72) Inventor: MATSUNAGA, Satoko, Tokyo 143-8564 (JP); SUZUKI, Shogo, Tokyo 143-8564 (JP); KOIZUMI, Shinya, Tokyo 143-8564 (JP); TAKAHASHI, Shinji, Tokyo 143-8564 (JP)
(74) Representative: Haley, Stephen
(86) International application number: PCT/JP2009/002289
(87) International publication number: WO 2010/137057

(57) **Abstract**

A cross fader unit, a mixer and a program which can achieve various music expressions with a simple manipulation are provided. A cross fader unit CF of the invention has an adjustment device by band 50 that adjusts a mixing rate of the audio signal in each frequency band by moving a plurality of the manipulation members each of which is a manipulation member by frequency band divided into a plurality of bands of the audio signal on a corresponding line 52.

## Description

### TECHNICAL FIELD

The present invention relates to a cross fader unit which adjusts a mixing rate of audio signals assigned to ends which are an A-end and a B-end by moving a manipulation member on a line connecting between both ends, a mixer and a program.

### BACKGROUND ART

There has been known a cross fader unit which can adjust a mixing rate of audio signals assigned to ends which are an A-end and a B-end by moving a manipulation member (tab, handling member) on a line connecting between both ends (for example, Patent Document 1). The cross fader unit is so structured that volume of the first audio signal becomes louder when the manipulation member is moved from the A-end to the B-end, whereas volume of the second audio signal becomes louder when the manipulation member is moved from the B-end to the A-end. Accordingly, the mixing rate of two kinds of audio signals can be adjusted simultaneously based on a position of the manipulation member. Thus, since the cross fader unit can achieve complex volume level control with one manipulation, it is frequently used in a DJ device (the device used for acoustic performance by a disc jokey (DJ)) such as a mixer in a club and the like.

Further, an equalizer device has been known as a unit mounted in the mixer. The equalizer unit is used for dividing band of the audio signal into high band, intermediate band and low band to adjust the volume. In the club and the like, a DJ gives complicated and unique performances by using a number of manipulation members of the above equalizer unit and the cross fader unit.

[Patent Document 1] JP-A-2004-5987

### DISCLOSURE OF THE INVENTION

### PROBLEMS THAT THE INVENTION IS TO SOLVE

However, it is extremely difficult for even a DJ to properly manipulate a plurality of manipulation members of the equalizer unit and the cross fader unit at the same time. Therefore, it is desirable to achieve various musical expressions with simple manipulations.

In view of the foregoing problem, it is an advantage of the invention to provide a cross fader unit, a mixer and a program which can achieve various musical expressions with simple manipulations.

### MEANS FOR SOLVING THE PROBLEMS

According to one aspect of the invention, there is provided a cross fader unit having an A-end and a B-end as both ends and adjusting a mixing rate of an audio signal assigned to each end by moving a manipulation member on a line connecting the both ends having an adjustment device by band that adjusts the mixing rate of the audio signal in each frequency band by a plurality of the manipulation members each of which is the manipulation member by frequency band divided into a plurality of bands of the audio signal.

According to the configuration, it is possible to adjust by frequency band the mixing rate of the audio signal assigned to the A-end and the B-end by a plurality of manipulation members by band corresponding to each frequency band simultaneously. In other words, it is possible to obtain an operation result of a case in which an equalizer device and a cross fader unit are operated concurrently with operations of the plurality of the manipulation members by band, which leads to fine and complex audio controls and various musical expressions by a single operation.
Note that the "plurality of manipulation members by band" may be through hardware or software. In other words, they may be manipulation members mounted physically or may be displayed by GUI on a touch panel with a display function and operated with a finger or a pointing device.

It is preferable that the cross fader unit mentioned above further have a display device by band that displays the mixing rate of the audio signal in each frequency band adjusted by the adjustment device by band.

According to the configuration, it is possible to check the mixing rate of the audio signal in each frequency band visually.
Note that the "display device by band" may express the mixing rate of the audio signal in each frequency band by images which represent the cross fader unit (which is displayed by GUI), or may express by diagrams, graphs, characters, digits, etc.

It is preferable that the adjustment device by band and the display device by band of the above mentioned cross fader unit be configured by a touch panel having a display function.

According to the configuration, since it is possible to realize the adjustment device by band and the display device by band by a touch panel having a display function (to operate on the cross fader unit displayed by GUI), the size and the cost thereof can be reduced.

It is preferable that the adjustment device by band of the above mentioned cross fader unit have a plurality of lines of which each length thereof is same and which are disposed in parallel having space thereamong so that the A-end and the B-end of each line are in alignment on a straight line.

According to the configuration, since the plurality of manipulation members by band can respectively move on different lines, operability of each manipulation member by band can be enhanced. Further, since the A-end and the B-end are disposed in parallel to align on one straight line, a setting area will be reduced and operability improvement will be further expected.
It is preferable that the "plurality of lines" be disposed in parallel on the basis of an order of corresponding frequency bands (from the lowest frequency or from the highest frequency).

It is preferable that the adjustment device by band of the above mentioned cross fader unit can adjust the mixing rate of the audio signal in a corresponding frequency band by being touched at an arbitrary position on each line corresponding to each frequency band.

According to the configuration, only by touching the arbitrary position on each line corresponding to each frequency band on the touch panel with the display function (without dragging each manipulation member on each line), the mixing rate of the audio signal in a corresponding frequency band can be adjusted. Therefore, by tracing intermediate positions on lines disposed, for example, in parallel vertically with respect to the lines, it is possible to assign (reset) evenly the mixing rate of audio signal assigned to each end.

It is preferable that the adjustment device by band of the above mentioned cross fader unit adjust from the mixing rate at the arbitrary position to a mixing rate at an assigned position assigned before the touch or at a predetermined position to change gradually or instantly when the touch at the arbitrary position of the line is released.

According to the configuration, it is possible to adjust the mixing rate of the audio signal from the arbitrary touched position to an assigned position assigned before the touch or to a predetermined position so as to change instantly or gradually.
A user may set which to move toward the assigned position or the predetermined position, whether moving instantly or gradually, and the like. In the case of moving gradually, the user may also set a moving speed and a moving time.

It is preferable that the adjustment device by band of the above mentioned cross fader unit hold the mixing rate at the arbitrary position after the release when the touch at the arbitrary position on the line is released.

According to the configuration, it is possible to hold the mixing rate at the arbitrary touched position as is after the release.
The user may set which to move toward the assigned position or the predetermined position, or to hold or not, and the like after the touch is released.

It is preferable that the adjustment device by band of the above mentioned cross fader unit adjust the mixing rate of the audio signal in a frequency band corresponding to each line to a maximum value viewed from the A-end side or the B-end side by manipulating a pair of maximum switching members provided at the A-end side and the B-end side of each line.

According to the configuration, it is easily possible to adjust the mixing rate of the audio signal assigned to each end to the maximum value or the minimum value by manipulating the pair of the maximum switching manipulation members (for example, in a case that the maximum switching manipulation member is a button, by pressing the button).

It is preferable that the above mentioned cross fader unit further have a spectrum analyzer display device that displays by spectrum analyzer by frequency band, and that the spectrum analyzer display device display an input level and an output level of the audio signal assigned to the A-end and the B-end as a minimum value at an intermediate position or the both ends on the line and as a larger value toward each end.

According to the configuration, it is possible to adjust the mixing rate of the audio signal assigned to each end while the spectrum analyzer display is checked.

It is preferable that the adjustment device by band of the above mentioned cross fader unit adjust a mixing rate of the audio signal in the corresponding frequency band while an upper limit value of the input level of the audio signal assigned to the A-end and the B-end in each frequency band is being displayed by the spectrum analyzer display device.

According to the configuration, it is possible to adjust the mixing rate of the audio signal assigned to each end while checking the upper limit value of the input level of the audio signal assigned to each end in each frequency band by the spectrum analyzer display device. Further, since the output level varies based on an adjustment of the mixing rate, it is possible to check a ratio of the output level to the input level.

It is preferable that the plurality of line corresponding to the plurality of frequency bands of the above mentioned cross fader unit be virtual lines and the spectrum analyzer display device display by spectrum analyzer of each frequency band corresponding to each line by overlapping with the plurality of virtual lines.

According to the configuration, since the mixing rate of the audio signal in each frequency band can be adjusted on the spectrum analyzer display device of each frequency by band, it is easily possible to check how the frequency bands correspond. Further, since the display of the mixing rate of the audio signal in each frequency band and the spectrum analyzer display are displayed overlappingly, a display area can be reduced. Still further, since the plurality of lines corresponding to the plurality of frequency bands are virtual, visibility of the spectrum analyzer display will not be lowered.

It is preferable that the cross fader unit mentioned above further have a main adjustment device that adjusts integrally mixing rates of audio signals in all the frequency bands independently from the adjustment device by band.

According to the configuration, since a known cross fader unit is provided as a main adjustment device, it is convenient when the mixing rates of the audio signals in all the frequency bands is adjusted integrally.

It is preferable that the adjustment device by band of the above mentioned cross fader unit adjust a mixing rate of an audio signal of the other frequency band except one or more than one assigned frequency bands among the plurality of frequency bands to a mixing rate adjusted by the main adjustment device.

According to the configuration, it is possible to adjust a mixing rate of the audio signal in the other frequency band except the assigned one or more than one frequency bands by the main adjustment device.

It is preferable that the adjustment device by band of the cross fader unit further have a reset device that instantly adjusts the mixing rates of the audio signals in all the frequency bands to the mixing rate adjusted by the main adjustment device.

According to the configuration, it is easily and quickly possible to reset the mixing rates of the audio signals in all the frequency bands to a same value (to adjust so as to be mixing rates adjusted by the main adjustment device).

It is preferable that the adjustment device by band of the above mentioned cross fader unit adjust, when a target value is set in either one of the plurality of frequency bands and the main adjustment device is adjusted, the mixing rate of the audio signal in the one frequency band to a mixing rate on a basis of the target value and adjust with variation the mixing rate of the audio signal in the other frequency band except the one frequency band on a basis of a band difference from the one frequency band.

According to the configuration, when the main adjustment device is adjusted to come closer to or to be away from the set target value, it is possible to adjust the mixing rate of the audio signal in the other frequency band by varying based on a band difference from the one frequency band set with the target value. In short, unique audio controls with variation can be implemented with a simple operation.
One specific example of "to adjust...with the target value" is: it is conceivable, when the main adjustment device is adjusted to come closer to the target value, that an adjustment start timing of each frequency band is delayed based on the band difference from the one frequency band (the larger the band difference is, the more the adjustment start timing is delayed) and the mixing rate comes closer to the target value. One the other hand, it is conceivable, when the main adjustment device is adjusted to be away from the target value, that the adjustment start timing of each frequency band is accelerated based on the band difference from the one frequency band (the larger the band difference is, the more the adjustment start timing is accelerated) and the mixing rate is away from the target value. According to the adjustment method, since large differences between adjacent frequency bands do not occur, natural (without sense of discomfort) audio controls can be achieved.

It is preferable that the adjustment device by band of the cross fader unit mentioned above conform the mixing rates of the audio signals in all the frequency bands to the target value when the adjustment by the main adjustment device coincides with the target value.

According to the configuration, it is possible to reset the mixing rates of the audio signals in all the frequency bands to the target value by adjusting to conform the main adjustment device to the target value.
As the specific example above, in the case that the mixing rate of the audio signal in the other frequency band is adjusted, it is preferable that a change amount of the mixing rate to a moving amount per unit of the main adjustment device from an adjustment start timing in the other frequency band be set largely based on a band difference (the more the band difference is, the larger the change amount is set).

It is preferable that the adjustment device by band of the cross fader unit mentioned above have a grouping device that divides the plurality of frequency bands in groups, and an adjustment device by group that adjusts a mixing rate of the audio signal in one or more than one frequency bands belonging to a same group simultaneously and in a same manner.

According to the configuration, it is possible to adjust the mixing rate of the audio signal by group. This makes it possible to manipulate a plurality of frequency bands with one finger (without using several fingers or both hands).

It is preferable that the adjustment device by group of the cross fader unit mentioned above adjust oppositely at least one group among the other groups when an adjustment of either one of groups among a plurality of groups that are grouped is made.

According to the configuration, since the adjustment to the other group can be performed in cooperation with the adjustment to the one group, it is possible to achieve more complex audio controls with one finger.

It is preferable that the adjustment device by band of the cross fader unit mentioned above adjust other frequency band based on a band difference from the one frequency band when either one of the frequency bands among the plurality of frequency bands is adjusted.

It is preferable that the adjustment device by band of the cross fader unit mentioned above adjust the other frequency band, when an adjustment to either one of the frequency bands among the plurality of the frequency bands is made, such that the mixing rate of the audio signal in the one frequency band after the adjustment becomes an upper or a lower limit value viewed from the A-end side or the B-end side and the mixing rate of the audio signal in the other frequency band gradually decreases or increases on a basis of the band difference.

According to these configurations, it is possible to adjust the other frequency band based on the band difference in cooperation with the adjustment of the one frequency band. In short, unique audio controls with variation can be achieved with a simple operation. Further, natural audio controls can be performed because the mixing rate is not quite different between adjacent frequency bands by adjusting such that the mixing rate of the audio signal in the other frequency band decreases or increases gradually based on the band difference.

It is preferable that the plurality of frequency bands in the cross fader unit mentioned above be divided with reference to a sound range of an instrument.

According to the configuration, audio controls in which a predetermined sound of an instrument is omitted can be performed.

A mixer of the invention has each device of the cross fader unit as set forth above, an audio signal input device through which the audio signal is input, a signal assignment device that assigns the input audio signal to the A-end or the B-end, and a mixing process device that performs a mixing process by frequency band based on an adjustment result by the adjustment device by band on the audio signal assigned to the A-end or the B-end.

A program of the invention is to cause a computer to function as each device in the cross fader unit mentioned above.

According to the configurations, it is possible to provide the mixer and the program which can implement various musical expressions with a simple operation.

### BRIEF DESCRIPTION OF THE DRAWINGS

FIG. 1 is a system structure diagram of a reproduction system according to an embodiment of the invention.
FIG. 2 is a diagram of a divided example of frequency bands and one example of an instrument corresponding to each frequency band.
FIGs. 3A to 3C are diagrams of an operation example (basic operation) of a cross fader unit.
FIGs. 4A and 4B are diagrams of an operation example (non-holding operation of a touch point) of the cross fader unit.
FIG. 5A to 5C are diagrams of an operation example (cooperative operation with a spectrum analyzer display) of the cross fader unit.
FIGs. 6A and 6B are diagrams of an operation example (cooperative operation (1) with a main adjustment device) of the cross fader unit.
FIGs. 7A and 7B are diagrams of an operation example (cooperative operation (2) with the main adjustment device) of the cross fader unit.
FIG. 8A and 8B are diagrams of an operation example (cooperative operation (3) with the main adjustment device) of the cross fader unit.
FIGs. 9A and 9B are diagrams of an operation example (cooperative operation (3) with the main adjustment device) of the cross fader unit following to FIG. 8B.
FIGs. 10A to 10C are diagrams of an operation example (group operation (1)) of the cross fader unit.
FIGs. 11A and 11B are diagrams of an operation example (group operation (2)) of the cross fader unit.
FIGs. 12A and 12B are diagrams of an operation example (cooperative operation based on manipulation of one manipulation member by band) of the cross fader unit.

### DESCRIPTION OF EXEMPLARY EMBODIMENTS

A cross fader unit, a mixer device and a program according to one embodiment of the invention will be explained in detail with reference to the accompanying drawings. In this embodiment, the cross fader unit of the invention applied to the mixer will be exemplified.

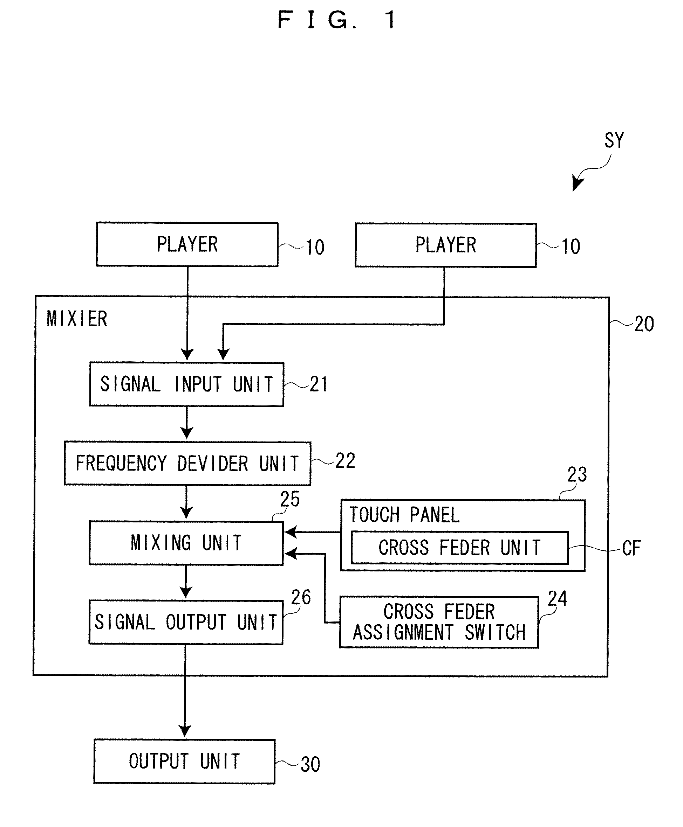

FIG. 1 is a system configuration diagram of a reproduction system SY applied with a mixer 20 of the invention. As illustrated in FIG. 1, the reproduction system SY has a plurality of players 10 (two players in FIG. 1), the mixer 20 which assigns audio signals input from the players 10 to each channel to perform a mixing process, and an output unit 30 which externally outputs the audio signals output from the mixer 20.

The players 10 read out numbers from an external memory medium such as a CD, a USB memory and an SD memory card or an internal memory medium such as a hard disc and reproduce them. Further, the output unit 30 includes an amplifier and speakers (not shown) and outputs the audio signals output from the mixer 20 as sounds. Still further, the players 10 and the mixer 20, and, the mixer 20 and the output unit 30 are connected to each other via audio cables such as RSA cable. A wireless connection may be employed in place of the cable connection.

The mixer 20 has a signal input unit 21, a frequency divider unit 22, a touch panel having a display function 23 (referred as a "touch panel 23" hereinafter), a cross fader assignment switch 24, a mixing unit 25 and a signal output unit 26.

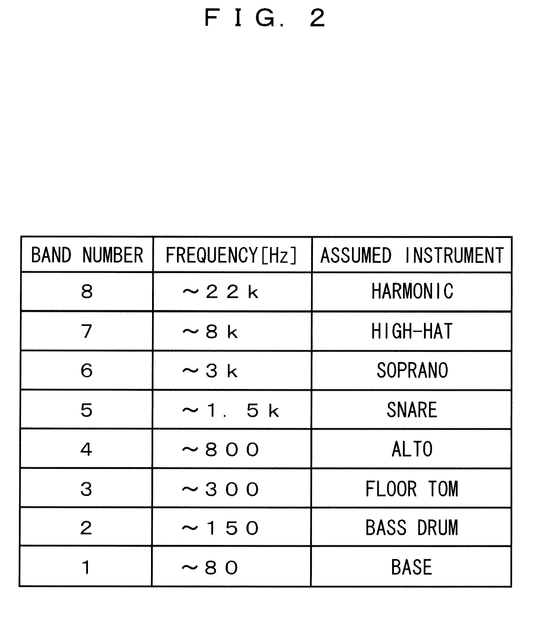

The signal input unit 21 has a plurality of input terminals (audio signal input device) to input audio signals from the plurality of players 10. The audio signal input from each input terminal is assigned to each channel and volume thereof is adjusted by a cross fader unit CF (described later), a channel fader (not shown) or the like. The frequency divider unit 22 divides the audio signal assigned to each channel into a plurality of frequency bands. In this embodiment, the audio signal is divided into eight frequency bands (see FIG. 2). The frequency divider unit 22 divides the frequency of the audio signal of each channel into same numbers and same ranges.

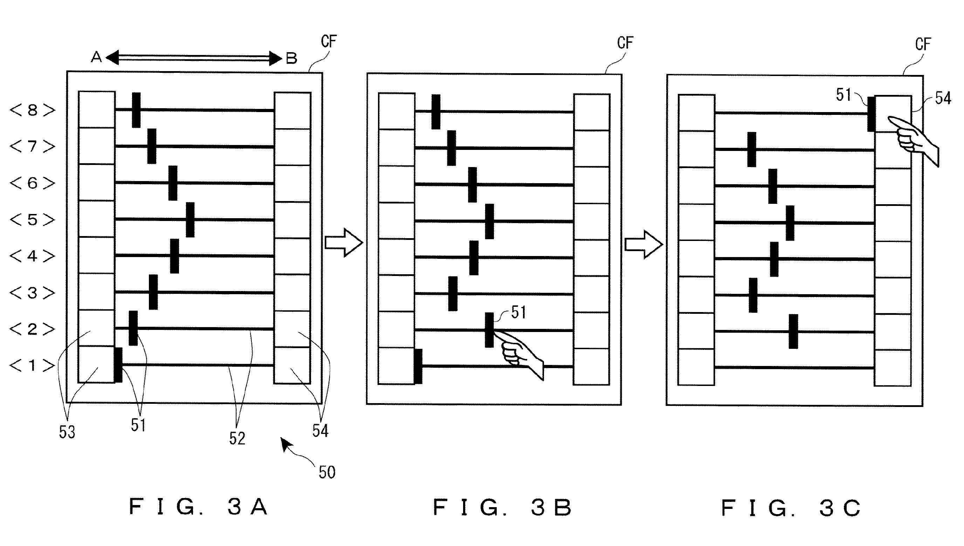

The touch panel 23 realizes the cross fader unit CF of the invention. The cross fader unit CF has an A-end and a B-end as end and adjusts a mixing rate of the audio signal assigned to each end by moving manipulation members 51 (manipulation members by band) on lines 52 connecting both ends. In this embodiment, the cross fader unit CF can adjust by frequency band (see FIG. 3 and the like). Therefore, the lines 52 and the manipulation members 51 are provided per frequency band (adjustment device by band 50).

The cross fader assignment switch 24 (signal assignment device) is a manipulation member used for selecting to assign the output of each channel to either both ends (an A-side or a B-side) of the cross fader unit CF or "through". In a case that a same side is selected for a plurality of channels, added output thereof is assigned. In a case that the "through" is selected, the output does not go through the cross fader unit CF and is output as is. It is possible to realize the cross fader assignment switch 24 on the touch panel 23.

The mixing unit 25 calculates the mixing rate of the audio signal assigned to each end of the cross fader unit CF based on a touch position signal generated by pressing an arbitrary point in the cross fader unit CF displayed on the touch panel 23 by a user. In the embodiment, as described above, since it is possible to adjust the mixing rates by frequency band, the mixing rate is calculated by frequency band. Further, based on the calculated mixing rates by frequency band, the audio signals are mixed in each frequency band (mixing process device). The signal output unit 26 has an output terminal through which the audio signals after the mixing process by the mixing unit 25 are output to the output unit 30.

Referring to FIG. 2, a plurality of frequency bands divided by the frequency divider unit 22 will be explained. FIG. 2 is a diagram of a divided example of the frequency bands and of an instrument example corresponding to each frequency band. As described above, in the embodiment, the band of the audio signal is divided into eight frequency bands. In the explanation hereinafter, for convenience sake, each frequency band is labeled with a band number <1> - - < 8 > from the lowest frequency. As illustrated in FIG. 2, the band number <1> covers a frequency band less than 80 Hz and a corresponding instrument thereof is supposes as a "base". The band number <2> covers a frequency band between equal to or more than 80 Hz and less than 150 Hz and a corresponding instrument thereof is assumed as a "bass drum". The other band numbers < 3 > - < 8 > are as described in FIG. 2.

Thus, since the plurality of frequency bands are configured by dividing on the basis of sound ranges of instruments rather than simply dividing the band of the audio signal equally, it is possible to perform an audio control such that a predetermined sound of an instrument is omitted by manipulating the plurality of manipulation members 51 provided by frequency band.

Referring to FIGs. 3A - 12B, specific operation examples of the cross fader unit CF will be explained. As described above, since the cross fader unit CF is included in the touch panel 23, in FIGs. 3A - 12B, the cross fader units CF displayed by GUI on the touch panel 23 are illustrated (display device by band).

FIGs. 3A to 3C are diagrams illustrating a basic operation of the cross fader unit CF. Referring to FIG. 3A, a structure of an adjustment device by band 50 will be explained. The adjustment device by band 50 includes eight manipulation members 51 provided by frequency band, eight lines 52 provided by frequency band, and a pair of maximum switching buttons 53, 54 (maximum switching manipulation members) provided on both ends of each line 52.

Each manipulation member 51 is formed in a strip shape. The members 51 are usually black in color, but the color changes depending on the situation. Further, each line 52 is, viewed from the user, a straight line extending in a horizontal direction and functions as movement path of each manipulation member 51. In short, each manipulation member 51 can be dragged along each line 52, and when an arbitrary point on each line 52 is touched, it can immediately move to the touched position (see the band number < 2 > in FIG. 3B).

Further, lines 52 are in a same length and are provided in parallel having predetermined space thereamong, by which the A-end and the B-end of the lines 52 position in alignment in a vertical direction. Still further, lines 52 are arranged from the bottom toward the top (from the front side toward the rear side viewed from the user) in order of small band number of a corresponding frequency band (in order of smaller frequency). Note that band number of each line 52 is illustrated with the sign <> > in figures which is not actually displayed on the touch panel 23.

Thus, the adjustment device by band 50 of the embodiment can adjust the mixing rate of audio signals in a corresponding frequency band only by touching an arbitrary point of each line 52 corresponding to each frequency band. Further, since lines 52 are aligned in parallel, the mixing rate of the audio signals assigned to each end can be adjusted to a same value by tracing an arbitrary position of each line 52 in a vertical direction (vertical direction with respect to the lines 52).

While, the pair of the maximum switching buttons 53, 54 includes the A-end side maximum switching button 53 provided at the A-end of each line 52 and the B-end side maximum switching button 54 provided at the B-end of each line 52. When the A-end side maximum switching button 53 is pressed (touched), the mixing rate of the audio signal assigned to the A-end side is adjusted to Max (maximum). Likewise, when the B-end side maximum switching button 54 is pressed, the mixing rate of the audio signal assigned to the B-end side is adjusted to Max (see the band number <8> in FIG. 3C). As such, it is possible to easily adjust the mixing rate of the audio signal assigned to each end to the maximum or minimum by providing the pair of the maximum switching buttons 53, 54.

It is possible for the user to set the display color and the form of each manipulation member 51, intervals of lines 52, display/hide of the maximum switching buttons 53, 54, and the like.

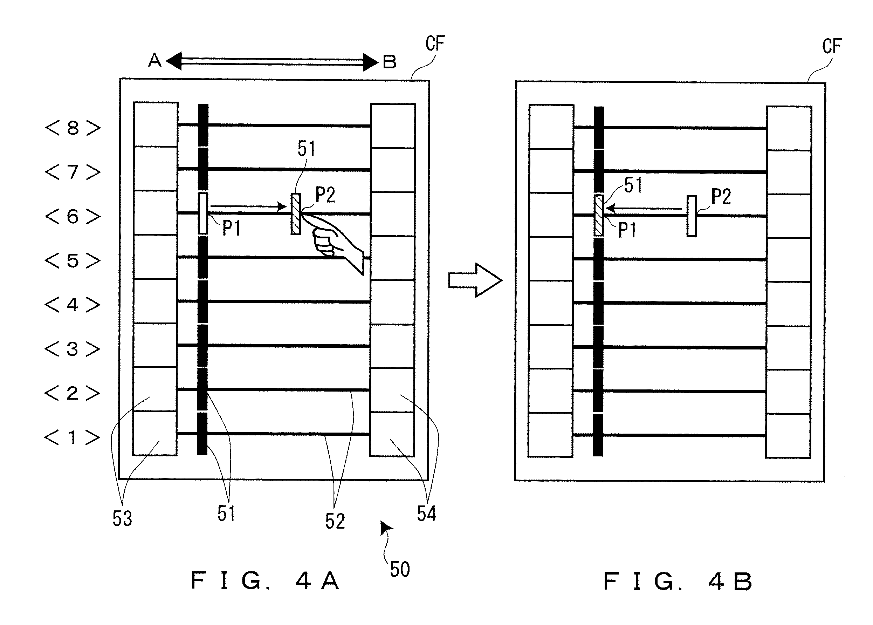

Referring to FIGs. 4A and 4B, a non-holding operation of a touch point will be explained. As illustrated in FIG. 4A, for example, when the manipulation member 51 of the band number <6> is dragged from a position P1 on the line 52 to a position P2 on the same line 52 and a touch is released, as illustrated in FIG. 4B, the adjustment device by band 50 of the invention can move the manipulation member 51 gradually from the position P2 to the position P1. In other words, in a case that the touch at an arbitrary point (position P2) is released, it is possible to adjust the mixing rate of the audio signals from the arbitrary point at which the touch has been released to a designated point (position P1) designated before the touch in such a way as to gradually move the manipulation member 51.

Thus, according to the non-holding operation at the touch point, it is possible to perform an audio control by changing the mixing rate gradually after the release of the touch, which can not be achieved with physical manipulation members.

The manipulation member may be moved instantly from the arbitrary point (positon P2) to the designated point (position P1), rather than gradually. Further, the manipulation member may be moved from the arbitrary point to a predetermined point (for example, Min or Max viewed from the A-end side, or, an intermediate point between the A-end and the B-end), rather than from the arbitrary point to the designated point designated before the touch. Still further, the arbitrary point may be designated by directly touching the position P2 after the point P1 has been touched, rather than dragging the manipulation member from the position P1 to the position P2.

The user may set setting/non-setting of the non-holding operation, gradual/instant movement, moving speed in a case of gradual movement, moving time in a case of gradual movement (time needed for moving from the arbitrary point to the designated or predetermined point), moving direction toward the designated point or the predetermined point, setting of the predetermined point, and the like.

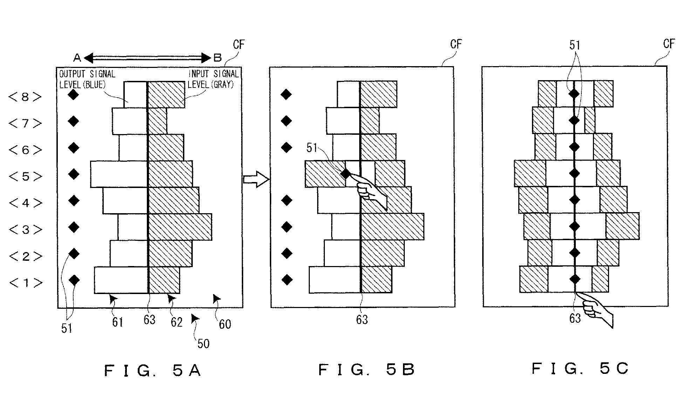

Referring to FIGs. 5A to 5C, a cooperative operation with a spectrum analyzer display will be explained. As illustrated in the figures, the adjustment device by band 50 of the embodiment can be operated on a spectrum analyzer display device 60. In this case, each manipulation member 51 is formed in diamond and each line 52 is not displayed (virtual line).

The spectrum analyzer display device 60 displays an input level and an output level of audio signals by frequency band assigned to each end as Min at an intermediate point 63 of each line 52 (in FIGs. 5A-5C, it is illustrated as a center line 63)), and as larger value toward each end (so that each end is Max). In other words, a left side from the intermediate point 63 is an A-end side audio signal display area 61 and a right side from the intermediate point 63 is a B-end side audio signal display area 62. The number of frequency bands and the ranges of each frequency band divided on the spectrum analyzer display device 60 are the same as those of the adjustment device by band 50 (see FIG. 2).

The spectrum analyzer display device 60 displays the input level and the output level in different display colors. For example, in a case that the input level is displayed in gray, the output level is displayed in blue, and all the manipulation members 51 position at the A-end as illustrated in FIG. 5A, since the output levels of the A-end side audio signals in all the frequency bands are Max, the A-end side audio signal display area 61 is displayed in blue overall (solid area in FIGs. 5A to 5C) and the B-end side audio signal display area 62 is displayed in gray overall (diagonal line area in FIGs. 5A-5C).

For example, the manipulation member 51 of the band number <5> is dragged from a state illustrated in FIG. 5A to a position illustrated in FIG. 5B toward the intermediate point 63, the display area in blue of the output level of the A-end side audio signals becomes smaller, while an upper limit value of the input level of audio signals at both ends is being displayed in gray. Also, with this change, the display area in blue of the output level of the B-end side audio signals becomes larger.

For example, as illustrated in FIG. 5C, when the intermediate point 63 of each line 52 is traced in a vertical direction, the audio signal assigned to each end can be mixed equally. In this case, in both the A-end side audio signal display area 61 and the B-end side audio signal display area 62, half area of the display area in gray of the input levels becomes the display area in blue of the output levels in all the frequency bands.

Thus, according to the example, since the spectrum analyzer display of each frequency band corresponding to each line 52 is made by overlapping on each line 52 of the adjustment device by band 50 of the embodiment, it is easily possible to recognize how the frequency band corresponds. Further, since the display of the mixing rate of the audio signal in each frequency band and the spectrum analyzer display are displayed overlappingly, it is possible to conserve space for the display area. Still further, in a case of cooperating with the spectrum analyzer display, since each line 52 is not indicated, it is possible to keep good visibility of the spectrum analyzer display.

Further, by the cooperative operation with the spectrum analyzer display, the user can adjust the mixing rate of the audio signal assigned to each end while cheking the spectrum analyzer display. Also, since it is possible to adjust while displaying the input level upper limit of the audio signal assigned to each end in each frequency band and only the output level is changed by the adjustment, the user can easily recognize the output state of the audio signal.

Note that whether the cooperation with the spectrum analyzer display is made or not (indication/non-indication of the spectrum analyzer display), the display color and the form of the manipulation members 51, indication/non-indication of the lines 52, the display colors of the input level and the output level and the like may be set by the user.

In the example above, though the spectrum analyzer display device 60 displays the input level and the output level of the audio signal by frequency band assigned to each end as Min which is the intermediate point 63 of each line 52, it may be possible to display both ends of each line 52 as Min such that a larger value is set toward to the other end. Further, it may be possible to display the both ends of each line 52 as Min and to display the intermediate point 63 as Max.

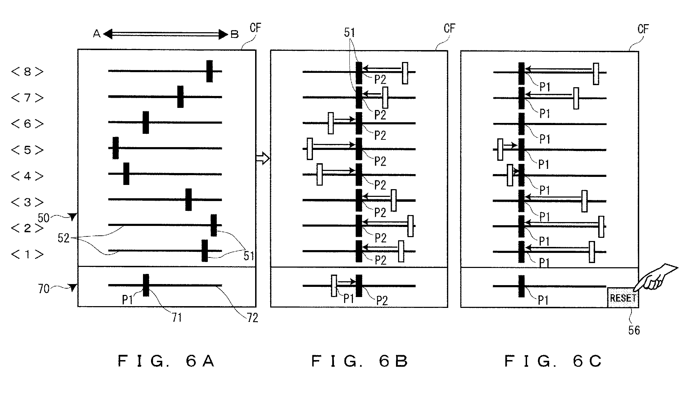

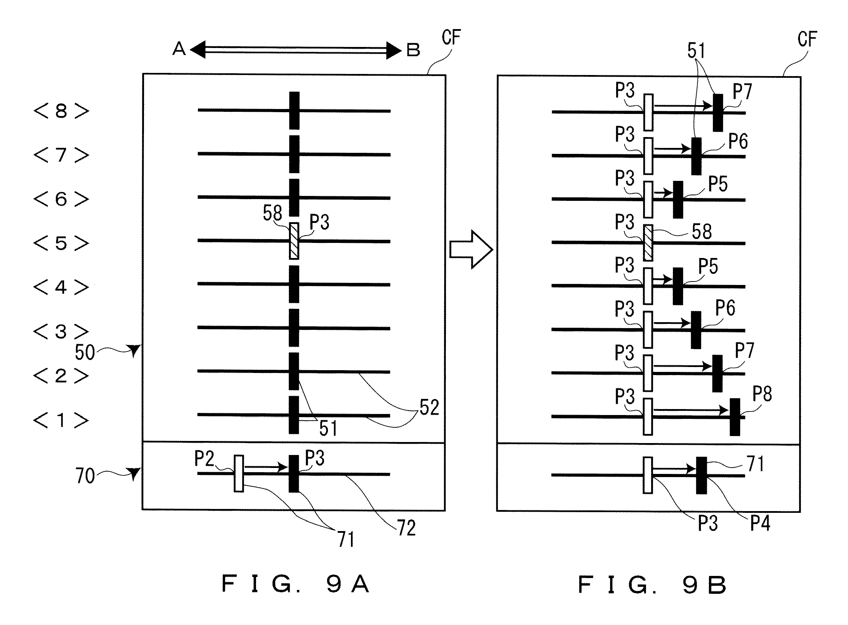

Referring to FIGs. 6A to 9B, a cooperative operation with a main adjustment device 70 will be explained. FIGs. 6A to 6C illustrate a cooperative operation (1) with the main adjustment device 70. As illustrated in the figures, the cross fader unit CF of the example has the adjustment device by band 50 and the main adjustment device 70. In figures illustrated hereinafter including FIG. 6A, the maximum switching buttons 53 and 54 (see FIG. 3A or the like) are omitted.

The main adjustment device 70 is a known cross fader unit which adjusts integrally mixing rates of audio signals in all the frequency bands independently from the adjustment device by band 50, and has a manipulation member 71 and a line 72 as moving path of the manipulation member 71. The main adjustment device 70 is provided at a lower side of the adjustment device by band 50 (the front side viewed from the user), and the manipulation member 71 and the line 72 are approximately in a same size and a same form as the manipulation members 51 and the lines 52 of the adjustment device by band 50.

In the adjustment device by band 50 of the example, when the manipulation member 71 of the main adjustment device 70 is moved from the position P1 to the position P2 (dragging movement or touching movement), for example, from a state of FIG. 6A to a state of FIG. 6B, all the manipulation members 51 of the adjustment device by band 50 cooperatively move with the manipulation member 71 of the main adjustment device 70 (the manipulation members 51 gather at the position P2).

As illustrated in FIG. 6C, by providing a reset button 56 (reset device), it is possible to achieve approximately the same operation as illustrated in FIG. 6B. In this case, when the reset button 56 is pressed in the state of FIG. 6A, all the manipulation members 51 of the adjustment device by band 50 gather at the position (position P1) on the manipulation member 71 of the main adjustment device 70. In the example of FIG. 6C, though the reset button 56 is provided near the main adjustment device 70, it may be provided at any other position (for example, near the adjustment device by band 50).

Thus, according to the cooperative operation (1) with the main adjustment device 70, since the main adjustment device 70 corresponding to the known cross fader unit is provided, it is convenient when the user desires to adjust the mixing rates of the audio signals in all the frequency bands integrally. Further, by providing the reset button 56, it is easily and quickly possible to reset the mixing rates of the audio signals in all the frequency bands at a same value (to adjust to the mixing rates adjusted by the main adjustment device 70).

The user may set whether the main adjustment device 70 is provided or not, the arrangement of the main adjustment device 70, whether the reset button 56 is provided or not, the position of the reset button 56, and the like.

In the example above, though the main adjustment device 70 is provided through software (displayed by GUI on the touch panel 23), it may be mounted through hardware (physically).

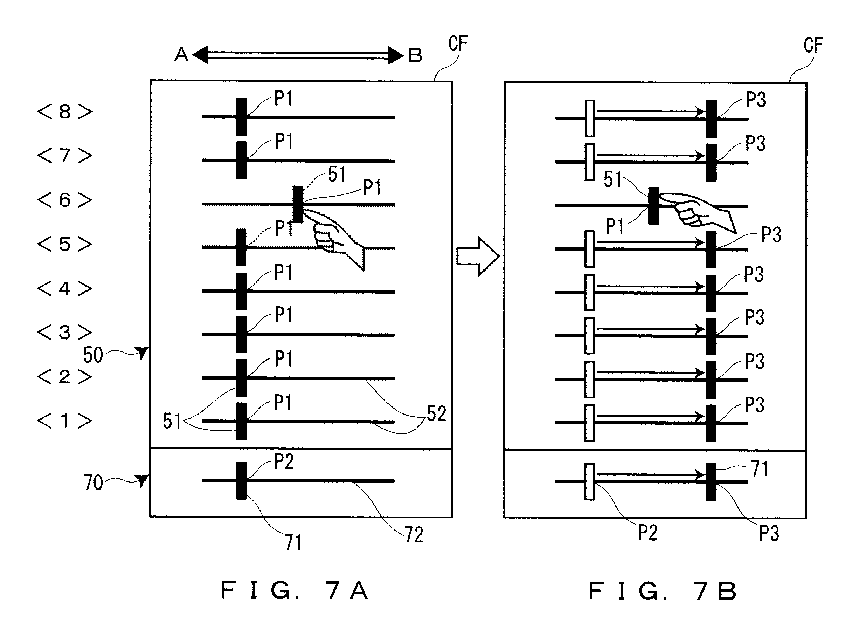

Referring to FIGs. 7A and 7B, a cooperative operation (2) with the main adjustment device 70 will be explained. While the manipulation member 51 of the band number <6> remains in a state of being touched as illustrated in FIG. 7A (in a state of being fixed at the position P1) and when the manipulation member 71 of the main adjustment device 70 is moved from the position P2 to a position P3 as illustrated in FIG. 7B, the manipulation members 51 of frequency bands except the band number <6> cooperatively move with the manipulation member 71 of the main adjustment device 70 (move from the position P2 to the position P3). In other words, it is possible to adjust the mixing rates of the audio signals in frequency bands except the assigned frequency band to the mixing rate adjusted by the main adjustment device 70. When the touch of the manipulation member 51 of the band number <6> is released and the manipulation member 71 of the main adjustment device 70 is moved, the manipulation member 51 of the band number <6> also cooperatively moves with the manipulation member 71 of the main adjustment device 70.

Thus, according to the cooperative operation (1) with the main adjustment device 70, it is possible to adjust the mixing rates of the audio signals in the frequency bands integrally, while the mixing rate of a desired sound range is fixed.

In the example above, though only one frequency band is assigned, by assigning a plurality of frequency bands, it may be possible to adjust the mixing rates of the audio signals in the remaining frequency bands other than assigned frequency bands by the main adjustment device 70. Further, in the example above, that the operation starts in a state where the manipulation member 71 of the main adjustment device 70 and manipulation members 51 other than that of the frequency number <6> are in a same position is exemplified, but other cases can be possible. For example, in the state illustrated in FIG. 6A, when an arbitrary manipulation member 51 is being touched and the manipulation member 71 of the main adjustment device 70 is moved, the same result illustrated in FIG. 7B can be obtained.

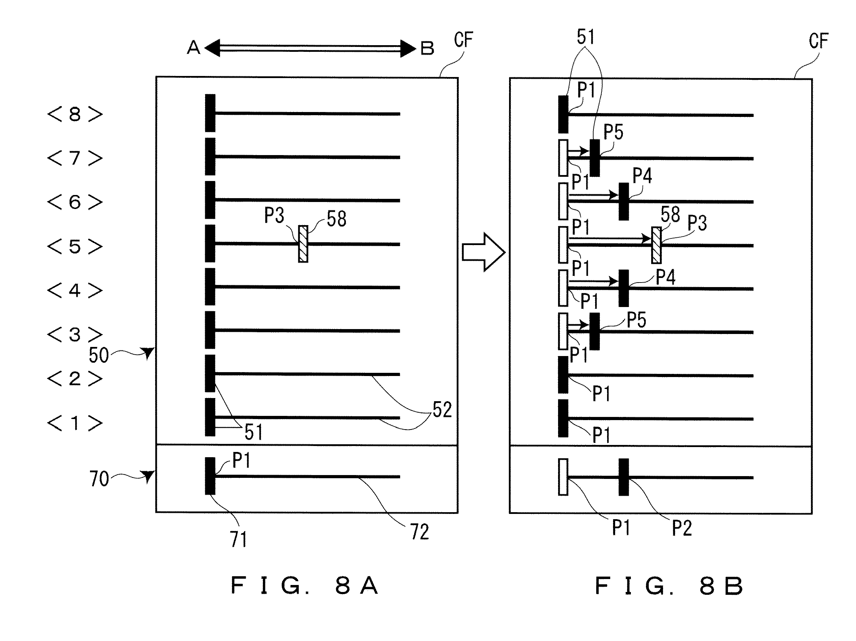

Next, referring to FIG. 8A to FIG. 9B, a cooperative operation (3) with the main adjustment device 70 will be explained. In this example, as illustrated in FIG. 8A, first of all, a target value 58 is set. The target value 58 can be set in any one of the plurality of frequency bands. Further, a display color of the target value 58 is different from that of the manipulation member 51 (for example, red) and the form thereof is approximately the same as that of the manipulation member 51. As a setting method, it is conceivable that a target value setting button (not shown) is pressed, and then, an arbitrary position on each line 52 is assigned.

For example, as shown in FIG. 8A, when the target value 58 is set at the position P3 on the band number <5> and the manipulation member 71 of the main adjustment device 70 is moved from the position P1 to be closer to the position P3, as illustrated in FIG. 8B, the manipulation members 51 in the frequency bands other than the band number <5> are moved toward the position P3, gradually delaying based on band differences (band number differences) from the number <5>. In other words, in a case that the main adjustment device 70 is adjusted to come closer to the target value 58, the mixing rate of the audio signal in one frequency band where the target value 58 is set is adjusted to be a mixing rate in response to the target value 58, and the mixing rates of the audio signals in other frequency bands are adjusted to come closer to the target value 58, delaying an adjustment start timing of each frequency band based on the band difference from the above one frequency band (the larger the band difference is, the slower the adjustment start timing is set).

Therefore, in a state that the manipulation member 71 of the main adjustment device 70 is positioned at the position P2 between the position P1 and the position P3, the band numbers <4> and <6> position at a position P4, the band numbers <3> and <7> position at a position P5, and the band numbers <1>, <2> and <8> position at the position P1 (a state where the manipulation members 51 have not started to move). The mixing rates viewed from the B-end side are: the position P3 > the position P4 > the position P5 > P1.

FIGs. 9A and 9B are diagrams illustrating the cooperative operation (3) with the main adjustment device 70 following to FIG. 8C. When the manipulation member 71 of the main adjustment device 70 is moved to the position P3 from the state illustrated in FIG. 8B, the manipulation members 51 in a11 the frequency bands of the adjustment device by band 50 gather at the position P3 as illustrated in FIG. 9A. In other words, when the main adjustment device 70 is adjusted to coincide to the target value 58, the mixing rates of the audio signals in all the frequency bands conform to the target value 58. Thus, a mixing rate change amount to a moving amount per unit of the main adjustment device 70 from the adjustment start timings in other frequency bands is set larger based on the band difference (the larger the band difference is, the larger the change amount is set).

Further, the manipulation member 71 of the main adjustment device 70 is moved away from the position P3 from the state illustrated in FIG. 9A, the manipulation members 51 in the frequency bands other than the band number <5> move away from the point P3, gradually preceding based on the band differences (band number differences) from the number <5>. In other words, in a case that the main adjustment device 70 is adjusted to move away from the target value 58, the mixing rate of the audio signal in one frequency band where the target value 58 is set is kept at the mixing rate in response to the target value 58, and the mixing rates of the audio signals in the other frequency bands are adjusted to be away from the target value 58, accelerating the adjustment start timing of each frequency band based on the band difference from the above one frequency band (the larger the band difference is, the faster the adjustment start timing is set).

Therefore, in a state that the manipulation member 71 of the main adjustment device 70 is positioned at the position P4 between the position P3 and the B-end, the band numbers <4> and <6> position at the position P5, the band numbers <3> and <7> position at a position P6, the band numbers <2> and <8> position at a position P7, and the band number <1> positions at a position P8. The mixing rates viewed from the B-end side are: the position P8 > the position P7 > the position P6 > the position P5 > the position P3.

Thus, according to the cooperative operation (3) with the main adjustment device 70, in a case that the main adjustment device 70 is adjusted to come closer to or to be away from the target value 58, it is possible to adjust the mixing rates of the audio signals in the other frequency bands with change based on the band difference from the one frequency band where the target value 58 has been set. In other words, it is possible to perform unique and various audio controls with a simple manipulation. Further, in a case that the main adjustment device 70 is adjusted to come closer to the target value 58, the adjustment start timings of the other frequency bands are adjusted to be delayed as the band differences from the one frequency band are larger. In a case that the main adjustment device 70 is adjusted to be away from the target value 58, the adjustment start timings of the other frequency bands are adjusted to be accelerated as the band differences from the one frequency band are larger. Therefore, natural audio controls (which does not make a user feel discomfort) can be achieved. Further, by adjusting the main adjustment device 70 to conform to the target value 58, the mixing rates of the audio signals in all the frequency bands can be easily reset to the target value 58.

When the main adjustment device 70 is adjusted not to coincide to the target value 58 but to set at the intermediate value (when the manipulation member 71 positions at the intermediate point between the A-end and the B-end), the mixing rates of the audio signals in all the frequency bands may be reset at the intermediate value.

Also, the user may set the adjustment start timings based on the band differences (band number differences), the change amount of the mixing rate to the moving amount per unit of the main adjustment device 70 based on the band difference (band number difference), the display color and the form of the target value 58, the position where the mixing rates of the audio signals in all the frequency bands are reset to a same value (the target value 58 or the intermediate value), and the like.

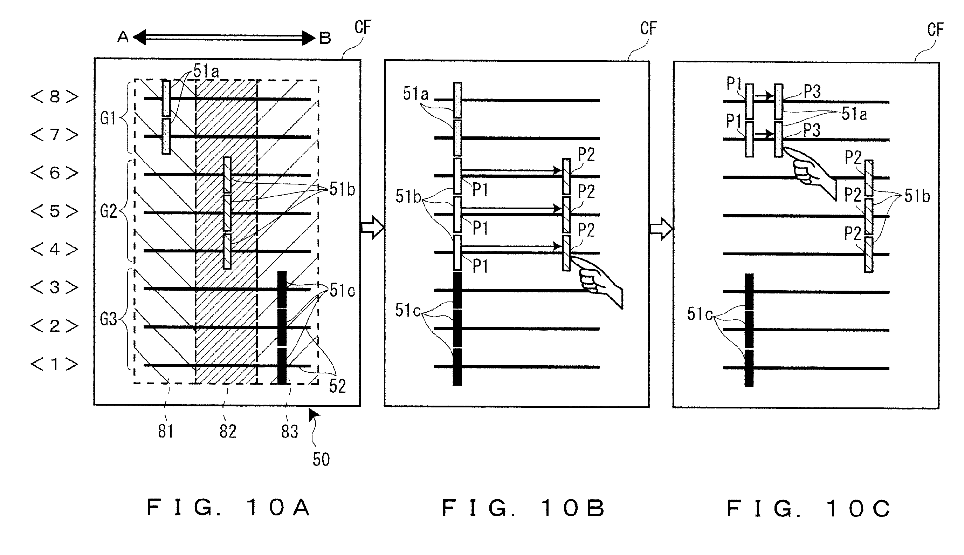

Referring to FIGs. 10A to 10C, a group operation (1) will be explained. In this example, a method by which eight manipulation members 51 of the adjustment device by band 50 is operated per group will be explained. First of all, referring to FIG. 10A, a grouping will be explained. When a grouping button (not shown) is pressed by the user, an operation area of the cross fader unit CF is divided into three areas 81, 82 and 83 and each of which is displayed in a different color. In this state, when each manipulation member 51 is positioned in either one of the areas, the manipulation members 51 within a same area (that is, frequency bands corresponding to the manipulation members 51 within a same area) are grouped as a same group (grouping device). For example, in a case that each manipulation member 51 is positioned as illustrated in FIG. 10A, two manipulation members 51a positioned in the area 81 are grouped as the first group G1, three manipulation members 51b positioned in the area 82 are grouped as the second group G2, and three manipulation members 51c positioned in the area 83 are grouped as the third group G3, respectively. After the grouping, when the grouping button is pressed again, the grouping is confirmed. The manipulation members 51 belonging to a same group have a same color.

After divided in groups as above, for example, as illustrated in FIG. 10B, when either one of the manipulation members 51b belonging to the second group G2 is moved from the position P1 to the position P2, the other manipulation members 51b belonging to the second group G2 are also moved cooperatively. Then, a touch on the second group G2 is released, the manipulation members 51b belonging to the second group G2 are held in the position. Further, as illustrated in FIG. 10C, either one of the manipulation members 51b belonging to the first group G1 is moved from the position P1 to the position P3, the other manipulation members 51a belonging to the first group G1 are also moved cooperatively. In short, when grouping is made, the mixing rates of the audio signals in one or more than one frequency bands belonging to a same group are adjusted simultaneously and in a same manner (adjustment device by group).

Thus, according to the group operation (1), the mixing rates of the audio signals can be adjusted per group unit. This allows the user to manipulate a plurality of frequency bands with the user's one finger (without using a plurality of fingers or both hands).

In the example above, though consecutive band numbers are grouped in a same group, discontinuous band numbers may be in a same group. Specifically, the frequency bands of the band numbers <1>, <3> and <5> may be grouped as in a same group. Further, in the example above, though the grouping is made into three groups G1, G2 and G3, it may be made into two or one group. In this case, one or two areas among the three areas 81, 82 and 83 will be used for grouping.

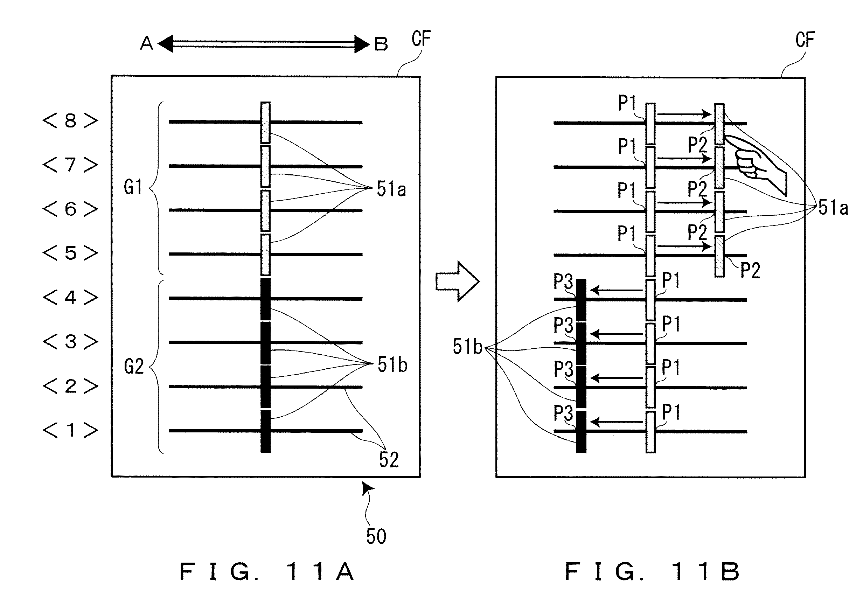

Referring to FIGs. 11A and 11B, a group operation (2) will be explained. For example, as illustrated in FIG. 11A, when manipulation members 51 are divided into two groups G1 and G2 and an opposing operation button (not shown) is pressed, as illustrated in FIG. 11B, an opposite operation by which manipulation members 51 move per group can be achieved. In the example of FIG. 11B, when either one of the four manipulation members 51a belonging to the first group G1 is moved from the position P1 to the position P2, the other manipulation members 51a belonging to the same first group G1 also move cooperatively and the four manipulation members 51b belonging to the second group G2 move in an opposite direction to the first group G1. In short, when either one of a plurality of groups which are grouped is adjusted, the adjustment device by band 50 of the example adjusts at least one group among the other groups oppositely (adjustment device by group).

Thus, according to the group operation (2), since the other group can be adjusted in connection with the adjustment of one group, more complicated and dynamic audio controls can be achieved with one finger.

In the example above, though the case in which two groups are made, even in a case that three or more than three groups are made, the group operation (2) can be applied. In this case, an adjustment is performed on one or more groups among groups which are not operation objects, the adjustment being opposite to an adjustment for a group which is an operation object. The group for the opposite operation object may be assigned every time the group operation is made or may be set beforehand (all the groups except the group to be the operation object may be assigned as opposite operation objects, only either one of groups except the group to be the operation object may be assigned as an opposite operation object, etc).

Regarding the group operation, the user may set the maximum number of groups (the number of areas 81, 82 and 83 illustrated in FIG. 10A), the display colors of the manipulation members 51 after grouped, whether the opposite operation should be performed or not, and the like.

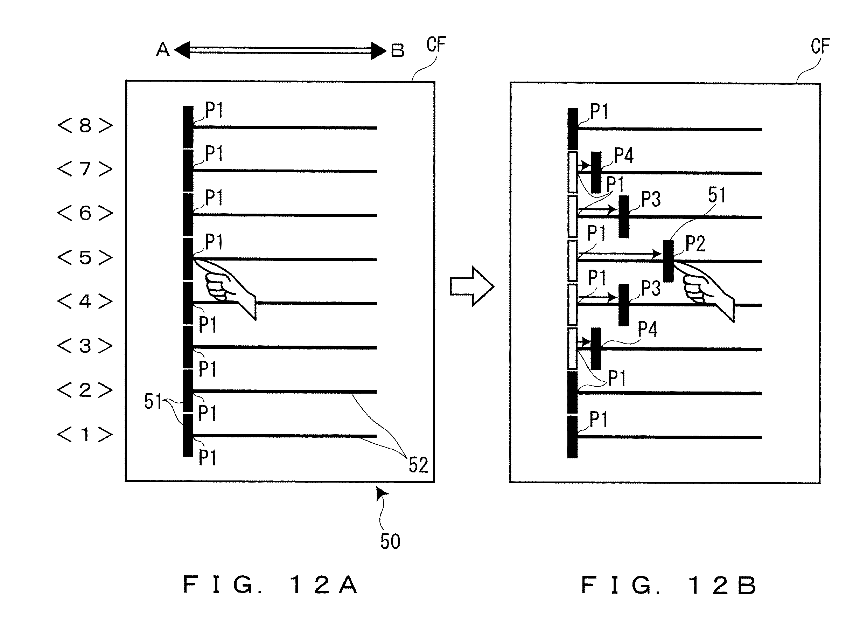

Referring to FIGs. 12A and 12B, a cooperative operation based on one manipulation member 51 will be explained. In this example, the adjustment on the basis of band differences by the cooperative operation (3) with the main adjustment device 70 as illustrated in FIGs. 8A to 9B can be achieved with the adjustment device by band 50 only.

For example, when the manipulation member 51 of the band number <5> is moved to the right (toward the B-end side) (FIG. 12B) from a state in which all the manipulation members 51 position at the A-end (point P1) (FIG. 12A), the manipulation members 51 of the frequency bands other than the band number <5> move in a same direction as the moving direction of the manipulation member 51 of the band number <5>, gradually delaying based on the band differences (band number differences) from the band number <5>. In other words, in the case that either one of the frequency band among a plurality of the frequency bands is adjusted to come closer to the B-end, the mixing rate of the audio signal in the one frequency band after the adjustment is an upper limit value viewed from the B-end side, and the mixing rates of the audio signals in the other frequency bands viewed from the B-end side are gradually decreased based on the band differences (so as to make the mixing rates smaller when the band difference is larger).

Therefore, in the state that the manipulation member 51 of the band number <5> positions at the position P2, the band numbers <4> and <6> position at the position P3, the band numbers <3> and <7> position at the position P4, and the band numbers <1>, <2> and <8> position at the position P1 (a state in which the manipulation members 51 thereof have not started to move). The mixing rates viewed from the B-end side are: the position P2 > the position P3 > the position P4> P1.

Though not especially illustrated, for example, also in a case that the manipulation member 51 of the band number <5> is moved to the right (toward the A-end side) from a state in which all the manipulation members 51 position at the B-end, as similar to the above example, the manipulation members 51 in the frequency bands other than the band number <5> move in a same direction in association with the movement of the band number <5>, gradually delaying based on the band differences (band number differences) from the band number <5>.

Thus, according to the cooperative operation on the basis of one manipulation member 51 operation, by working together with an adjustment for one frequency band, it is possible to adjust the other frequency bands based on band differences. In short, unique audio controls with variation can be achieved with a simple manipulation. Further, natural audio controls can be performed because mixing rate differences of adjacent frequency bands are not made larger by adjusting to decrease the mixing rates of the audio signals in the other frequency bands gradually based on band differences.

In the example above, in the case that one frequency band to be an operation object is adjusted to come closer to the B-end, the adjustments for the other frequency bands are performed such that the adjusted mixing rate of the audio signals in the one frequency band is the upper limit value viewed from the B-end side, but it is possible to adjust it to a lower limit value. In other words, the manipulation member 51 of the band number <5> is moved, for example, to the right, the other manipulation members 51 may move toward the B-end, preceding to the movement of the manipulation member 51 of the band number <5>. In this case, at the time when the manipulation member 51 of the band number <5> arrives at the position P2, the manipulation members 51 as a whole make a form of "angulation". Also in a case that the manipulation member 51 of the band number <5> is moved toward the A-end, the adjusted mixing rate of the audio signal in one frequency band to be an operation object may be set as the lower limit value viewed from the A-end side.

When the manipulation member 71 to be an operation object positions at the A-end or the B-end, the mixing rates of the audio signals in all the frequency bands of the adjustment device by band 50 may be adjusted to Max viewed from the A-end or the B-end. In this case, the change rates of the mixing rates of the other frequency bands to a moving amount per unit of a frequency band to be an operation object from adjustment start timings in the other frequency bands need to be set larger based on band differences (the change amount is set larger when the band differences are larger).

The user may set whether the adjusted mixing rate of the audio signal in one frequency band to be an operation object is set to be an upper limit value or a lower limit value viewed from an end of a destination side, adjustment start timings based on band differences (band number differences), change amounts of the mixing rates of the other frequency bands to a moving amount per unit of a frequency band to be an operation object, and the like.

As explained above, according to the embodiment, it is possible to adjust by frequency band the mixing rates of the audio signals assigned to the A-end and the B-end simultaneously by the adjustment device by band 50. Further, unique and complex audio controls can be achieved because various manipulations as above can be performed, leading to various music expressions.

Further, in the embodiment, since the cross fader unit CF is displayed by GUI by realizing the adjustment device by band 50 on the touch panel 23, it is not necessary to provide a separate display device for visually recognizing the mixing rate of the audio signal in each frequency band. Therefore, it is possible to downsize a structure of the mixer 20 and to make it cheaper.

In the above embodiment, though the adjustment result of the adjustment device by band 50 can be checked on the touch panel 23, a display device for checking the adjustment result may be provided separately. In this case, the adjustment result may be expressed as diagrams, graphs, characters, digits and the like. The adjustment device by band 50 may be configured with physically mounted manipulation members.

Further, in the embodiment above, though each line 52 of the adjustment device by band 50 is disposed from the lower side which corresponds to the lower frequency band to the upper side which corresponds to the higher frequency band, the order may be reversed. Specifically, the band numbers <1> - <8> may be changed to band numbers <8> - <1>. Still further, they are not necessarily positioned in parallel in frequency order, but the order is arbitrary such as the band numbers <1>, <3>, <5>, <7>, <2>, <4>, <6> and <8>. Moreover, lines 52 are not necessarily positioned in parallel and may be positioned as sides constituting a polygon or intersecting with one another.

In the embodiment above, though the lines 52 are provided per frequency band, they may be provided jointly. In other words, a plurality of manipulation members 51 corresponding to a plurality of frequency bands may move on one line 52. The lines 52 are not necessarily straight lines, but may be curved lines or dotted lines.

In the embodiment above, though the case in which the adjustment device by band 50 is divided into eight frequency bands for the adjustment is exemplified (see FIG. 2), the user may set freely the number of division and bandwidth of each frequency band.

Also, each structure unit of the mixer 20 described above can be provided as a program. The program can also be stored and provided in various types of recording mediums (a CD-ROM, a flash memory, etc). Therefore, a program which makes a computer function as each structure unit of the mixer 20 and a recording medium in which the program has been recorded are included in a scope of the invention.

The mixer 20 described in the above embodiment may be applied to an electronic instrument or a computer. The user may set selectable operations among operations illustrated in FIG. 3A to FIG. 12B. Further, each operation above may be implemented in combination. Other alternations may be made without departing from the scope of the invention.

### [Reference Numerals]

10: player 20: mixer 21: signal input unit 22: frequency divider unit 23: touch panel 24: cross fader assignment switch 25: mixing unit 26: signal output unit 30: output device 51: manipulation member (adjustment device by band) 52: line (adjustment device by band) 56: reset button 58: target value 71: manipulation member (main adjustment device) 72: line (main adjustment device) CF: cross fader unit Pn (n=1, 2...): position of the manipulation member SY: reproduction system

## Claims

1. A cross fader unit having an A-end and a B-end as both ends and adjusting a mixing rate of an audio signal assigned to each end by moving a manipulation member on a line connecting the both ends comprising:
an adjustment device by band that adjusts the mixing rate of the audio signal in each frequency band by a plurality of the manipulation members each of which is the manipulation member by frequency band divided into a plurality of bands of the audio signal.

2. The cross fader unit according to claim 1, further comprising a display device by band that displays the mixing rate of the audio signal in each frequency band adjusted by the adjustment device by band.

3. The cross fader unit according to claim 2, wherein the adjustment device by band and the display device by band are configured by a touch panel having a display function.

4. The cross fader unit according to claim 3, wherein the adjustment device by band has a plurality of lines of which each length thereof is same and which are disposed in parallel having space thereamong so that the A-end and the B-end of each line are in alignment on a straight line.

5. The cross fader unit according to claim 4, wherein the adjustment device by band can adjust the mixing rate of the audio signal in a corresponding frequency band by being touched at an arbitrary position on each line corresponding to each frequency band.

6. The cross fader unit according to claim 5, wherein the adjustment device by band adjusts from the mixing rate at the arbitrary position to a mixing rate at an assigned position assigned before the touch or at a predetermined position to change gradually or instantly when the touch at the arbitrary position of the line is released.

7. The cross fader unit according to claim 5, wherein the adjustment device by band holds the mixing rate at the arbitrary position after the release when the touch at the arbitrary position on the line is released.

8. The cross fader unit according to claim 4, wherein the adjustment device by band adjusts the mixing rate of the audio signal in a frequency band corresponding to each line to a maximum value viewed from the A-end side or the B-end side by manipulating a pair of maximum switching members provided at the A-end side and the B-end side of each line.

9. The cross fader unit according to claim 4 further comprising a spectrum analyzer display device that displays by spectrum analyzer by frequency band, wherein the spectrum analyzer display device displays an input level and an output level of the audio signal assigned to the A-end and the B-end as a minimum value at an intermediate position or the both ends on the line and as a larger value toward each end.

10. The cross fader unit according to claim 9, wherein the adjustment device by band can adjust a mixing rate of the audio signal in the corresponding frequency band while an upper limit value of the input level of the audio signal assigned to the A-end and the B-end in each frequency band is being displayed by the spectrum analyzer display device.

11. The cross fader unit according to claim 9, wherein the plurality of lines corresponding to the plurality of frequency bands are virtual lines and the spectrum analyzer display device displays by spectrum analyzer each frequency band corresponding to each line by overlapping with the plurality of virtual lines.

12. The cross fader unit according to claim 3 further comprising a main adjustment device that adjusts integrally mixing rates of audio signals in all the frequency bands independently from the adjustment device by band.

13. The cress fader unit according to claim 12, wherein the adjustment device by band adjusts a mixing rate of an audio signal of other frequency band except one or more than one assigned frequency bands among the plurality of frequency bands to a mixing rate adjusted by the main adjustment device.

14. The cross fader unit according to claim 12, wherein the adjustment device by band has a reset device that instantly adjusts the mixing rates of the audio signals in all the frequency bands to the mixing rate adjusted by the main adjustment device.

15. The cross fader unit according to claim 12, wherein the adjustment device by band adjusts, when a target value is set in either one of the plurality of frequency bands and the main adjustment device is adjusted, the mixing rate of the audio signal in the one frequency band to a mixing rate on a basis of the target value and adjusts with variation the mixing rate of the audio signal in the other frequency band except the one frequency band on a basis of a band difference from the one frequency band.

16. The cross fader unit according to claim 15, wherein the adjustment device by band conforms the mixing rates of the audio signals in all the frequency bands to the target value when the adjustment by the main adjustment device coincides with the target value.

17. The cross fader unit according to claim 1, wherein the adjustment device by band has a grouping device that divides the plurality of frequency bands in groups, and an adjustment device by group that adjusts a mixing rate of the audio signal in one or more than one frequency bands belonging to a same group simultaneously and in a same manner.

18. The cross fader unit according to claim 17, wherein the adjustment device by group adjusts oppositely at least one group among the other groups when an adjustment of either one of groups among a plurality of groups that are grouped is made.

19. The cross fader unit according to claim 1, wherein the adjustment device by band adjusts other frequency band based on a band difference from one frequency band when either one of the frequency bands among the plurality of frequency bands is adjusted.

20. The cross fader unit according to claim 19, wherein the adjustment device by band adjusts the other frequency band, when an adjustment to either one of the frequency bands among the plurality of the frequency bands is made, such that the mixing rate of the audio signal in the one frequency band after the adjustment becomes an upper or a lower limit value viewed from the A-end side or the B-end side and such that the mixing rate of the audio signal in the other frequency band gradually decreases or increases on a basis of the band difference.

21. The cross fader unit according to claim 1, wherein the frequency band is divided with reference to a sound range of an instrument.

22. A mixer comprising:
each device of the cross fader unit as set forth in any one of claims 1 to 21;
an audio signal input device through which the audio signal is input;
a signal assignment device that assigns the input audio signal to the A-end or the B-end; and
a mixing process device that performs a mixing process by frequency band on the audio signal assigned to the A-end or the B-end based on an adjustment result by the adjustment device by band.

23. A program that causes a computer to function as each device in the cross fader unit in any one of claims 1 to 21.
